# EUROPÄISCHE PATENTSCHRIFT

(11) **EP 3 360 398 B1**
(45) Veröffentlichungstag und Bekanntmachung des Hinweises auf die Patenterteilung: **07.10.2020**
(21) Anmeldenummer: 16754473.3
(22) Anmeldetag: 15.08.2016
(51) Int. Cl.: H05K 5/00, B60R 16/023, F16H 61/00

(54) **GETRIEBESTEUERMODUL FÜR EIN KRAFTFAHRZEUG**
TRANSMISSION CONTROL MODULE FOR A MOTOR VEHICLE
MODULE DE COMMANDE DE BOÎTE DE VITESSES CONÇU POUR UN VÉHICULE AUTOMOBILE

(30) Priorität: 08.10.2015 DE 102015219466
(43) Veröffentlichungstag der Anmeldung: 15.08.2018
(73) Patentinhaber: Robert Bosch GmbH, 70442 Stuttgart (DE)
(72) Erfinder: ZWEIGLE, Peter, 71254 Ditzingen (DE); DROIGK, Thorsten, 71640 Ludwigsburg (DE)
(86) Internationale Anmeldenummer: PCT/EP2016/069340
(87) Internationale Veröffentlichungsnummer: WO 2017/059994

(56) Entgegenhaltungen:
- EP-A1- 0 880 655
- EP-A2- 1 672 328
- WO-A1-01/36847
- DE-A1-102009 047 621
- DE-A1-102011 085 054
- DE-A1-102011 085 170
- DE-A1-102011 085 172
- DE-A1-102013 222 855

## Beschreibung

### Gebiet der Erfindung

Die Erfindung betrifft ein Getriebesteuermodul für ein Kraftfahrzeug.

### Stand der Technik

Zur Steuerung von Automatikgetrieben werden elektronische Steuerungen verwendet, die im Inneren des Getriebegehäuses angeordnet sind. Zur elektrischen Leitungsführung werden beispielsweise flexible Leiterplatten oder umspritzte Stanzgitter eingesetzt. Die elektronischen Steuerungen sind integrierte Getriebesteuermodule und weisen in der Regel ein Elektronikmodul mit einer elektronischen Schaltung ("transmission control unit", TCU), wenigstens einen Sensor, mindestens eine Steckverbindung zum Anschluss an einen Fahrzeugkabelbaum und elektrische Schnittstellen zur Ansteuerung von Aktuatoren auf. Stanzgitter werden als Leiterbahnstanzgitter eingesetzt, um Steuergeräte elektrisch zu kontaktieren. Es ist bekannt, für eine elektrische Leitungsführung dabei umspritzte Stanzgitter zu verwenden. Die Leiterbahnstanzgitter bzw. Leitungsstanzgitter sind zur Erzielung eines niedrigen elektrischen Widerstands aus Cu-Legierungen hergestellt. Bei Kontakt des Kupfers mit dem aggressiven Getriebeöl, das nicht elektrisch leitend ist, entstehen jedoch Reaktionsprodukte, die zu elektrischen Funktionsbeeinträchtigungen führen. Daher werden die Kupferleiterbahnen durch eine Oberflächenbeschichtung und andere konstruktive, aufwändige Maßnahmen geschützt. Die Leitungsstanzgitter werden beispielsweise in mehreren Fertigungsschritten umspritzt und gegebenenfalls werden verschiedene Kunststoffschichten miteinander verschweißt, um ein Eindringen in die umspritzte Hülle von Fluiden in ein Leitungsstanzgitter zu vermeiden.

Die DE 10 2011 088 031 A1 beschreibt ein Getriebesteuermodul. Die EP 1 672 328 A2 offenbart einen Magnetfeldsensor für eine Getriebeanwendung. Steuermodule für Getriebeanwendungen sind weiterhin auch aus der EP 0 880 655 A1, aus der DE 10 2009 047 621 A1 und aus der DE 10 2011 085 170 A1 bekannt. Aus der DE 10 2013 222 855 A1 ist ein als Stanzgitter aus mit Aluminium walzplattierten Kupfer gefertigtes Leadframe bekannt.

### Offenbarung der Erfindung

### Vorteile der Erfindung

Ausführungsformen der vorliegenden Erfindung ermöglichen in vorteilhafter Weise, auf aufwändige Konservierungsmaßnahmen des Leitungsstanzgitters in mehreren Fertigungsschritten zu verzichten und ein zuverlässiges und robustes Getriebesteuermodul bereitzustellen.

Gemäß einem ersten Aspekt der Erfindung wird ein Getriebesteuermodul eines Kraftfahrzeugs geschaffen, aufweisend ein Elektronikmodul mit einer elektrischen Schaltung, ein Stanzgitter, mindestens einen Sensor zur Lagerung im Innenraum eines Getriebes, mindestens einen Steckverbinder zur Verbindung eines elektrischen Anschlusses zwischen dem Innenraum und Äußeren eines Getriebes, wobei das Stanzgitter elektrisch leitend mit dem Elektronikmodul, dem mindestens einen Sensor und dem mindestens einen Steckverbinder verbunden ist. Das erfindungsgemäße Getriebesteuermodul zeichnet sich insbesondere dadurch aus, dass das Getriebesteuermodul im Inneren eines Getriebes lagerbar ist und das Stanzgitter aus einer Aluminiumlegierung hergestellt ist.

Ideen zu der vorliegenden Erfindung können als auf den folgenden Gedanken und Erkenntnissen basierend angesehen werden. Da das Stanzgitter aus KupferLegierungen im aggressiven Getriebeöllager und eine vollständige Abdichtung nicht ausreichend zufriedenstellend möglicherweise realisierbar ist, wird das Stanzgitter aus einer Aluminiumlegierung hergestellt. Hierbei kann das Stanzgitter aus einem hochreinen Aluminium mit sehr hohen Reinheitsgraden oder auch mit Zusätzen von Magnesium (Mg) und/oder Mangan (Mn) zur Optimierung mechanischer Festigkeiten oder als Korrosionsschutz eingesetzt sein. Der Vorteil eines Stanzgitters in Aluminiumlegierung ist, dass dieses im Getriebeöl äußerst korrosionsbeständig ist und keiner wesentlichen Ummantelungen und zusätzlichen Beschichtungen bedarf.

Um einen ebenfalls niedrigen elektrischen Widerstand wie bei KupferLegierungen zu erreichen, weist das erfindungsgemäße Stanzgitter vergrößerte Werkstoffquerschnitte auf. Die Werkstoffquerschnitte sind vergrößert im Gegensatz zu Leitungsstanzgittern aus einer Cu-Legierung.

Trotzdem ergibt sich ein weiterer konstruktiver Vorteil dadurch, dass ein Stanzgitter aus einer Al-Legierung gegenüber einer Cu-Legierung ein leichteres Gewicht im Getriebe mit sich bringt.

Gemäß der vorliegenden Erfindung umfasst das Getriebesteuermodul Zwischenleiterbleche, die an jedem Leitungsende an einer Leitung von dem Stanzgitter zum Elektronikmodul, dem mindestens einen Sensor und dem mindestens einen Steckverbinder angeordnet sind. Der Einsatz von Zwischenleiterblechen vereinfacht die Fertigungsschritte des Getriebesteuermoduls dadurch, in dem wesentliche herkömmliche Verfahrensschritte beibehalten werden können.

Desweiteren umfassen die Zwischenleiterbleche ein Abschnittsende mit einer Al-Legierung und ein gegenüberliegendes Abschnittsende mit einer Cu-Legierung. Der Vorteil derartiger Zwischenleiterbleche ist, dass diese kostengünstig verfügbar sind und einen kostengünstigen Übergang von einer Legierung zu einer anderen Legierung, hier der Al-Legierung zur Cu-Legierung als elektrisch leitendes Bauelement ermöglichen. Trotzdem sind derartige Legierungsbleche deutlich kostenintensiver als reine Al-Legierungsbleche oder reine Cu-Legierungsbleche. Deshalb sind diese speziellen Bleche auf Zwischenleiterbleche reduziert.

Gemäß einem die Erfindung weiterführenden Aspekt ist das Al-Legierungs-Stanzgitter mit einer Al-Al-Kontaktverschweißung an seinen Enden der Leitungen mit den Abschnitten mit der Al-Legierung der Zwischenleiterbleche verschweißt und die Leitungsenden des Elektronikmoduls des Sensors und des Steckverbinders sind mit dem Cu-Legierungs-Abschnittsende des jeweiligen Zwischenleiterblechs verschweißt. Somit sind die bisherigen Verbindungstechniken für den Stecker bzw. die Steckverbindung, den mindestens einen Sensor und das Elektronikmodul weiterhin möglich. Ein Verschweißen, Stecken, Löten, Bonden etc. bedarf somit keiner Änderung im Fertigungsverfahren. Auch ein Übergang vom Stanzgitter, das beispielsweise komplett oder nur teilweise für eine mechanische Fixierung umspritzt ist, kann durch eine Al-Al-Kontaktverschweißung kostengünstig einfach mit den jeweiligen Abschnittsenden der Zwischenleiterbleche verschweißt werden.

Gemäß einer bevorzugten Ausführungsform umfasst zumindest eine Oberflächenschicht eines Abschnittsendes eine Al-Legierung oder insbesondere eine Cu-Legierung, wobei das Zwischenleiterblech entsprechend aus einem massiven Komplementärwerkstoff, der eine Cu-Legierung oder insbesondere einer Al-Legierung umfasst, hergestellt ist. Dies hat den Vorteil, dass gegebenenfalls nur ein kleiner Bereich des Abschnittsendes das komplementäre Kontaktmaterial aufweisen muss, wohingegen das Zwischenleiterblech aus einem massiven Werkstoff hergestellt ist. Es versteht sich, dass der Bereich des Zwischenleiterblechs, der mit dem Öl des Getriebes kontaktieren kann, zumindest eine Al-Oberfläche aufweist.

Gemäß einer alternativen bevorzugten Ausführungsform sind die Zwischenleiterbleche aus einem walzplattierten Kombiblech hergestellt. Das Kombiblech umfasst, wie oben beschrieben, an einem Abschnitt eine Al-Legierung und am anderen Abschnittsende eine Cu-Legierung.

Gemäß einer die Erfindung weiterbildenden Ausführungsform ist der Abschnitt des Zwischenleiterblechs, der zumindest eine Cu-Legierungs-Oberfläche oder eine massive Cu-Legierung umfasst, in einem gegen Getriebeöl abgedichteten Bereich in mindestens einem Sensor, in mindestens einem Steckverbinder und/oder im Elektronikmodul angeordnet. Es wird somit ein Kontakt von freien Cu-Legierungsoberflächen mit dem Getriebeöl verhindert. Eine Kontaktkorrosion oder leitende Ablagerungen werden somit vermieden.

Gemäß einer die Erfindung weiterbildenden Ausführungsform ist der Abschnitt des Zwischenleiterblechs, der im Getriebeöl abgedichteten Bereich angeordnet, in einer Vergussmasse eingebettet. Eine Vergussmasse, beispielsweise ein Duroplast oder ähnliche aus dem Stand der Technik bekannte Vergussmasse, bietet einen wirksamen Schutz gegenüber dem Eindringen oder der Umgebung von aggressivem Getriebeöl. Somit sind die Kontaktkorrosion-gefährdeten Oberflächen gegenüber einen Getriebeöl abgedichtet. Bevorzugt ist beispielsweise bei einem Sensor oder einem Steckverbinder diese Vergussmasse in einem Gehäuse mit dem Sensorelement oder dem entsprechenden Steckelement mitvergossen.

Gemäß einer alternativen Ausführungsform ist der Cu/Al-Übergangsbereich des Zwischenleiterblechs außerhalb eines Dichtwerkstoffbereichs geschützt vor externen Fluiden in einem Gehäuseinnenraum des Steckverbinders angeordnet. Bei entsprechenden Anwendungen ist es möglich den Gehäuseinnenraum außerhalb eines Dichtwerkstoffbereichs anzuordnen.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind. Es zeigen
- Fig. 1: eine Querschnittsansicht eines erfindungsgemäßen Getriebesteuermoduls;
- Fig. 2: eine Querschnittsansicht eines erfindungsgemäßen Sensors gemäß einer ersten Ausführungsform;
- Fig. 3: eine Querschnittsansicht eines erfindungsgemäßen Sensors gemäß einer zweiten Ausführungsform vom Getriebesteuermodul;
- Fig. 4: eine perspektivische Ansicht eines erfindungsgemäßen Elektronikmoduls eines Getriebesteuermoduls und
- Fig. 5: eine Querschnittsansicht eines Sensors gemäß einer alternativen Ausführungsform.

Die Figuren sind lediglich schematisch und nicht maßstabsgetreu dargestellt. Gleiche Bezugszeichen bezeichnen in den Figuren gleiche oder gleichwirkende Merkmale.

### Ausführungsformen der Erfindung

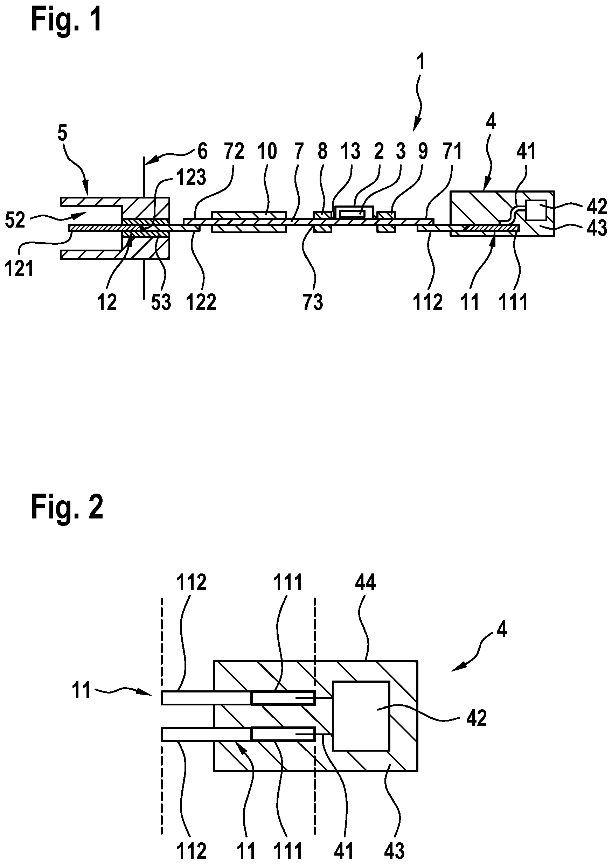

Fig. 1 zeigt im Querschnitt gesehen ein Getriebesteuermodul 1 eines Kraftfahrzeugs, wie es in einem Getriebeinnenraum, beispielsweise eines Automatikgetriebes, verbaut wird. Der Getriebeinnenraum ist mit einem aggressiven Getriebeöl gefüllt. Das Getriebesteuermodul 1 umfasst ein Elektronikmodul 2 mit einer elektrischen Schaltung 3 und mindestens einen Sensor 4 sowie mindestens einen Steckverbinder 5. Der Steckverbinder 5 dient dazu, Steuersignale an und von dem Elektronikmodul 2 nach außen außerhalb eines Getriebes mit einer Getriebewand 6 zu übertragen. Das Getriebesteuermodul 1 umfasst ferner ein Stanzgitter 7 zur elektrischen Leitungsverbindung zwischen dem Elektronikmodul 2, dem mindestens einen Sensor 4 und dem mindestens einen Steckverbinder 5. Das Stanzgitter 7 ist ein entsprechend auf den speziellen Getriebeinnenraumtyp konstruiertes und zugeschnittenes Stanzgitter 7. Das Stanzgitter 7 ist mittels mechanischer Fixierungen 8, 9, 10 an der Gehäusewand 6 im Getriebeinnenraum montiert. Die mechanischen Fixierungen 8, 9, 10 sind teilweise oder komplett um das Stanzgitter 7 gespritzt. Die mechanische Fixierung 10 umfasst beispielsweise eine komplette Umspritzung des Stanzgitters, wohingegen die Fixierung 8 und 9 nur eine teilweise Umspritzung umfassen.

Erfindungsgemäß ist das Stanzgitter 7 aus einer Aluminiumlegierung hergestellt. Die AI-Legierung kann sehr reines Aluminium sein oder zur Erzeugung bestimmter mechanischer und chemischer Eigenschaften weitere andere Metallwerkstoffanteile umfassen, beispielsweise Mangan und Magnesium. Das Stanzgitter 7 zur Leitung von elektrischen Leitungen hat den Vorteil, dass es gegenüber einem Stanzgitter 7 aus einer Cu-Legierung, keine zusätzliche Oberflächenbeschichtung oder andere konstruktiv aufwändige Maßnahmen zum Abdichten gegenüber Getriebeöl benötigt. Ein direkter Kontakt mit dem Getriebeöl ist möglich, es besteht keine Korrosionsgefahr. Zudem ist ein Stanzgitter 7 aus Aluminium bezüglich des Gewichts beispielsweise für ein Automatikgetriebe um ca. 50 bis 100 g leichter gegenüber einem Stanzgitter aus einer Cu-Legierung. Das Stanzgitter 7 ist in den Leitungsquerschnitten gegenüber einem Leitungsstanzgitter aus einer Cu-Legierung vergrößert, um einen äquivalenten oder nahezu äquivalenten elektrischen Widerstand wie bei einer Cu-Legierung zu erzeugen.

Das Stanzgitter 7 ist zur Verbindung mit einem Sensor 4 an ein spezielles Zwischenleiterblech 11 verschweißt. Ebenso ist der Steckverbinder 5 an das Stanzgitter 7 mit einem Zwischenleiterblech 12 verschweißt. Das Elektronikmodul 2 ist über Zwischenleiterbleche 13 an Enden 73 des Stanzgitters 7 verschweißt.

Die Zwischenleiterbleche 11, 12, 13 zeichnen sich dadurch besonders aus, dass ein Abschnittsende 112, 122, 132 eine Al-Legierung und das gegenüberliegende Abschnittsende 111. 121, 131 eine Cu-Legierung umfasst. Derartige Zwischenleiterbleche 11, 12, 13 sind beispielsweise durch Walzplattieren aufgrund neuerer Entwicklungen verfügbar. Derartige kombinierte Bleche aus zwei Metalllegierungen sind gegenüber einem Stanzgitter aus einer einheitlichen Legierung sehr kostenintensiv.

Ein Stanzgitter 7 in Aluminium ist deutlich kosteneffizienter, als wenn ein spezielles Kombiblech mit Aluminium- und Kupfer-Legierungsanteilen eingesetzt werden würde. Ein Stanzgitter 7 hat einen hohen Verschnittanteil von ca. 75 bis 80%. Ferner ist ein Stanzgitter 7 aus einer Al-Legierung deutlich günstiger als ein Stanzgitter aus einer Cu-Legierung.

Deshalb sind diese spezifischen kombinierten Bleche auf kleine Zwischenleiterbleche 11, 12, 13 reduziert. Zwischenleiterbleche 11, 12, 13 haben den Vorteil, dass eine Al-Al-Kontaktverschweißung an den Enden der Leitungen vom Stanzgitter 7 mit den AI-Legierungs-Abschnitten 112, 122, 132 der Zwischenleiterbleche 11, 12, 13 mit herkömmlichen Verbindungstechnologien leichter durchführbar ist. Ebenso sind die gegenüberliegenden Abschnittsenden 111, 121 der Zwischenleiterbleche 11, 12 mit den Leitungsenden 41, 33 des jeweiligen Sensors 4, Steckverbinders 5 und vom Elektronikmodul 2 mit einer entsprechenden Cu-Legierungsverschweißung hergestellt. Die bisherigen bekannten Verbindungstechniken, wie Schweißen, Stecken, Löten, Bonden etc., die bei einer Leiterplatte aus einer Cu-Legierung eingesetzt werden, können auch bei dem erfindungsgemäßen Getriebesteuermodul aufgrund der besonderen Zwischenleiterbleche 11, 12, 13 mit ihren Cu-Legierungsabschnittsenden 111, 121, 131 eingesetzt werden.

Der Sensor 4 umfasst somit einmal das Sensorelement 42, daran anschließend elektrische Leitungen 41, die mit dem Cu-Legierungsabschnittsende 111 des Zwischenleiterblechs 11 elektrisch leitend verbunden sind. Der Sensor 4 ist in einer Vergussmasse 43, beispielsweise einem gegen das Getriebeöl resistenten Kunststoff, vergossen, in dem das Sensorelement 42 mit dem Anschlusskontakt 41 und dem Zwischenleiterblech 11 angeordnet ist, wobei lediglich das Abschnittsende 112, das eine Al-Legierung aufweist, aus dem Sensor 4 herausragt.

Der Steckverbinder 5 weist einen Cu/Al-Übergangsbereich 123 auf. Dieser Cu/Al-Übergangsbereich 123 des Zwischenleiterblechs 12 liegt in einer Vergussmasse 53, die öldicht ist und im Gehäuse von der Steckverbindung 5 ebenfalls öldicht angeordnet ist. Der Steckverbinder 5 ist ebenso in der Getriebewand 6 öldicht verbaubar.

Das Zwischenleiterblech 12 des Steckverbinders 5 ist an beiden Seiten offen. An dem Cu-Legierungsabschnitt 121 ist ein entsprechender Stecker oder eine Buchse angeordnet, um eine entsprechend komplementäre Steckverbindung aufzunehmen. Das gegenüberliegende Ende 122 des Zwischenleiterblechs 12 ist mit einem Leitungsende 72 des Stanzgitters 7 verschweißt. Der Cu/Al-Übergangsbereich 123 des Zwischenleiterblechs 12 beim Steckverbinder 5 kann auch so weit in der Fig. 1 linksseitig angeordnet sein, dass er außerhalb des Dichtwerkstoffbereichs mit der Vergussmasse 53 liegt. Der Cu-Legierungsabschnitt 121 liegt somit geschützt vor Fluiden des Getriebeinnenraums in einem Gehäuseinnenraum 52 des Steckverbinders 5. Der Al-Abschnitt 122 des Zwischenleiterblechs 12 erstreckt sich somit durch den Dichtwerkstoffbereich bis zum Ende 72 des Stanzgitters 7.

Fig. 2 zeigt einen vergrößerten Querschnitt eines Sensors 4 für das erfindungsgemäße Getriebesteuermodul 1. Der Sensor 4 weist das Sensorelement 42 auf, das beispielsweise die Stellung von Getriebezahnrädern detektiert. Zwei Leitungsanschlüsse des Sensorelements 42 sind mit ihren Kontakten am Abschnittsende 111 jeweils eines Zwischenleiterblechs 11 elektrisch leitend fest verbunden. Das Abschnittsende 111 weist zumindest auf der Oberfläche eine Cu-Legierung auf. Bevorzugt ist das Zwischenleiterblech 11 ein sogenanntes Kombiblech, wobei der Abschnitt 111 massiv aus einer Cu-Legierung hergestellt ist und der gegenüberliegende Abschnitt 112 aus einer Al-Legierung. Die zwei Zwischenleiterbleche 11 sind mit dem Sensorelement 42 in einer Vergussmasse 43 öldicht vergossen und in einem Gehäuse 44 eingebettet. Lediglich die Abschnittsenden der Al-Legierung der Zwischenleiterbleche 111 stehen aus dem Gehäuse 44 und der Vergussmasse 43 heraus. Alternativ ist ein Gehäuse 44 nicht notwendig, weil die Vergussmasse 43 eine ausreichende Formstabilität gewährleistet.

Ebenso kann ein Steckverbinder 5 in analoger Weise aufgebaut sein.

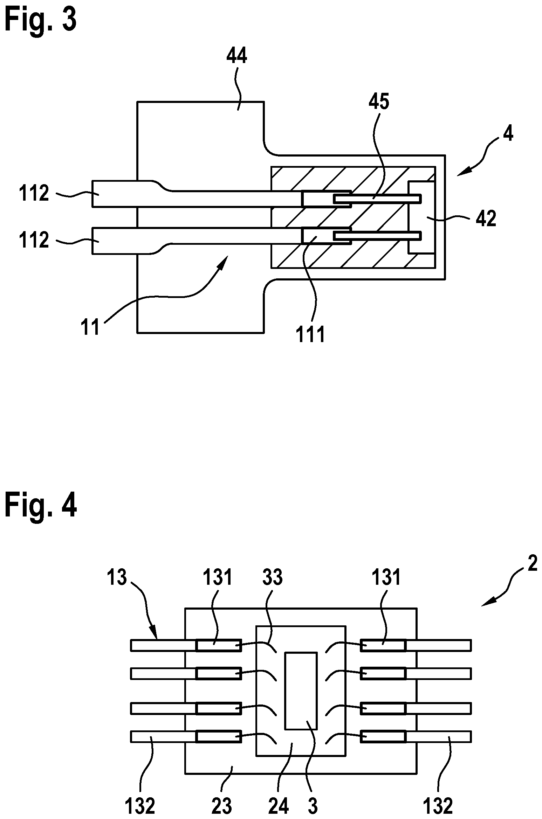

Fig. 3 zeigt im Querschnitt gesehen eine alternative Ausführungsform eines Sensors 4 oder Steckverbinders 5, der im Gegensatz zur Fig. 2 nicht lediglich mit einer Vergussmasse 43 als äußere Begrenzung im Getriebeöl liegend hergestellt ist, sondern bei dem das Sensorelement 42 mit den beiden Zwischenleiterblechen 11 und Übergangsblechen 45 in einer beispielsweise duroplastischen Vergussmasse 43 eingebettet sind, die wiederum mit einem Kunststoff, beispielsweise einem Thermoplasten, in einem größeren Gehäuse 44 umspritzt sind. In diesem Fall sind die Abschnitte 112 mit einer Al-Legierung deutlich größer und verlängert ausgebildet, um durch die zusätzlich zum Teil etwas dickere Kunststoffumspritzung hindurchzutreten. Das Sensorelement 42 kann ebenfalls einen anwendungsspezifischen Chip, ASIC, umfassen. Die Übergangsbleche 45 sind ebenfalls aus einer Cu-Legierung hergestellt und verbinden das Sensorelement 42 mit dem kurzen Abschnitt 111 des Zwischenleiterblechs 11.

Die Fig. 4 zeigt schematisch die Draufsicht eines Elektronikmoduls 2 mit einer elektrischen Schaltung 3 eingebettet. Die elektrische Schaltung 3 ist in Form eines Chips in einem Hartkunststoff bereits ummantelt. Cu-Kontakte 33 des Elektronikmoduls 2 sind mit den Cu-Legierungsabschnitten 131 der Zwischenleiterbleche 13 jeweils durch bekannte elektrisch leitende Verbindungstechniken elektrisch leitend verbunden. Die elektrische Schaltung 3 mit dem Gehäuse 24 sowie die daran gebundenen Zwischenleiterbleche 13 sind in einer Vergussmasse 23 zu einem öldichten Elektronikmodul 2 vergossen, so dass lediglich die Al-Legierungsabschnitte aus dem Elektronikmodul 2 hervorstehen. Die Al- Legierungsabschnitte 132 sind, wie in der Fig. 1 dargestellt, mit dem Al-Legierungsstanzgitter 7 mittels einer Al-Al-Kontaktverschweißung elektrisch leitend verbunden.

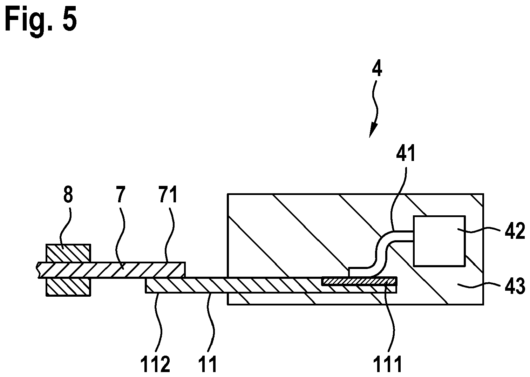

Die Fig. 5 zeigt schematisch eine alternative Ausführungsform eines Zwischenleiterblechs 11 bei einem Sensor 4. Das Zwischenleiterblech 11 ist ein sogenanntes Kombiblech, das im Wesentlichen aus Al hergestellt ist, wobei lediglich ein kleiner Abschnitt und davon lediglich ein Teil der Oberfläche einen Cu-Legierungsanteil aufweist. Der Anschlusskontakt 41 des Sensorelements 42 ist hier mit dem Cu-Legierungs-Abschnittsende 111 herkömmlich elektrisch leitend verbunden. Das Sensorelement 42 ist mit dem Zwischenleiterblech 11, wie zur Fig. 2 beschrieben, mit einer Vergussmasse 43 umspritzt. Somit ist das Sensorelement 42 mit den Cu-Kontakten und dem Cu-Al-Übergangsbereich des Zwischenleiterblechs 11 gegenüber einem aggressiven Getriebeöl abgedichtet. Das Stanzgitter 7 ist mit einer mechanischen Fixierung 8 fixiert und am Abschnittsende 71 mit dem Abschnitt 112 des Zwischenleiterblechs 11 verschweißt.

Abschließend ist darauf hinzuweisen, dass Begriffe wie "aufweisend", "umfassend", etc. keine anderen Elemente oder Schritte ausschließen und Begriffe wie" eine" oder "ein" keine Vielzahl ausschließen. Bezugszeichen in den Ansprüchen sind nicht als Einschränkung anzusehen.

## Patentansprüche

1. Getriebesteuermodul (1) eines Kraftfahrzeugs aufweisend:
ein Elektronikmodul (2) mit einer elektrischen Schaltung (3),
ein Stanzgitter (7),
mindestens einen Sensor (4) zur Lagerung im Innenraum eines Getriebes, mindestens einen Steckverbinder (5) zur Verbindung eines elektrischen Anschlusses zwischen dem Innenraum und Äußeren eines Getriebes,
wobei das Stanzgitter (7) elektrisch leitend mit dem Elektronikmodul (2), dem mindestens einen Sensor (4) und dem mindestens einen Steckverbinder (5) verbunden ist, wobei das Getriebesteuermodul (1) im Innenraum eines Getriebes lagerbar ist, **dadurch gekennzeichnet, dass** das Stanzgitter (7) aus einer Aluminiumlegierung hergestellt ist und das Getriebesteuermodul (1) Zwischenleiterbleche (11, 12, 13) umfasst, die an jedem Leitungsende (71, 72) einer Leitung von dem Stanzgitter (7) zum Elektronikmodul (2), dem mindestens einen Sensor und dem mindestens einen Steckverbinder (5) angeordnet sind, wobei die Zwischenleiterbleche (11, 12, 13) ein Abschnittsende (112, 122, 132) mit einer AI-Legierung und ein gegenüberliegendes Abschnittsende (111, 121, 131) mit einer Cu-Legierung umfassen und somit einen Cu-/Al-Übergangsbereich (123) aufweisen.

2. Getriebesteuermodul (1) nach Anspruch 1, **dadurch gekennzeichnet, dass** das Stanzgitter (7) mit einer Al-Al-Kontaktverschweißung an seinen Enden (71, 72, 73) der Leitungen mit den Abschnitten (112, 122, 132) mit der Al-Legierung der Zwischenleiterbleche (11, 12, 13) verschweißt ist und Leitungsenden (33, 41) des Elektronikmoduls (2), des Sensors (4) und des Steckverbinders (5) mit einem Cu-Legierungs-Abschnittsende (111, 121, 131) des jeweiligen Zwischenleiterblechs (11, 12, 13) verschweißt sind.

3. Getriebesteuermodul (1) nach Anspruch 1, **dadurch gekennzeichnet, dass** zumindest eine Oberflächenschicht eines Abschnittsendes (111) des Zwischenleiterblechs (11, 12, 13) eine AI-Legierung oder insbesondere eine Cu-Legierung umfasst und das Zwischenleiterblech (11, 12, 13) entsprechend aus einem massiven Komplementärwerkstoff eine Cu-Legierung oder insbesondere einer Al-Legierung hergestellt ist.

4. Getriebesteuermodul (1) nach Anspruch 1, **dadurch gekennzeichnet, dass** die Zwischenleiterbleche (11, 12, 13) aus einem walzplattierten Kombiblech hergestellt sind.

5. Getriebesteuermodul (1) nach Anspruch 3 oder 4, **dadurch gekennzeichnet, dass** der Abschnitt (111, 121, 131) des Zwischenleiterblechs (11, 12, 13), der zumindest eine Cu-Legierungs-Oberfläche oder eine massive Cu-Legierung umfasst, in einem gegen Getriebeöl abgedichteten Bereich im mindestens einen Sensor (4), im mindestens einen Steckverbinder (5) und/oder im Elektronikmodul (2) angeordnet ist.

6. Getriebesteuermodul (1) nach Anspruch 5, **dadurch gekennzeichnet, dass** der Abschnitt des Zwischenleiterblechs (11, 12, 13), der im Getriebeöl abgedichteten Bereich angeordnet ist, in einer Vergussmasse (43, 53, 23) eingebettet ist.

7. Getriebesteuermodul (1) nach einem der Ansprüche 4, 5 oder 6, **dadurch gekennzeichnet, dass** der Cu/Al-Übergangsbereich (123) des Zwischenleiterblechs (12) außerhalb eines Dichtwerkstoffbereichs geschützt vor externen Fluiden in einem Gehäuseinnenraum (52) des Steckverbinders (5) angeordnet ist.

## Claims

1. Transmission control module (1) of a motor vehicle, having:
an electronics module (2) with an electrical circuit (3), a leadframe (7),
at least one sensor (4) for mounting in the interior of a transmission,
at least one plug-in connector (5) for connecting an electrical connection between the interior and exterior of a transmission,
wherein the leadframe (7) is electrically conductively connected to the electronics module (2), to the at least one sensor (4) and to the at least one plug-in connector (5), wherein the transmission control module (1) can be mounted in the interior of a transmission, **characterized in that** the leadframe (7) is produced from an aluminium alloy and the transmission control module (1) comprises intermediate conductor plates (11, 12, 13) which are arranged at each line end (71, 72) of a line from the leadframe (7) to the electronics module (2), to the at least one sensor and to the at least one plug-in connector (5), wherein the intermediate conductor plates (11, 12, 13) comprise a section end (112, 122, 132) containing an aluminium alloy and an opposite section end (111, 121, 131) containing a copper alloy and therefore have a copper/aluminium transition region (123).

2. Transmission control module (1) according to Claim 1, **characterized in that** the leadframe (7) is welded by way of an aluminium/aluminium contact weld at its ends (71, 72, 73) of the lines to the sections (112, 122, 132) containing the aluminium alloy of the intermediate conductor plates (11, 12, 13), and line ends (33, 41) of the electronics module (2), of the sensor (4) and of the plug-in connector (5) are welded to a copper alloy section end (111, 121, 131) of the respective intermediate conductor plate (11, 12, 13).

3. Transmission control module (1) according to Claim 1, **characterized in that** at least one surface layer of a section end (111) of the intermediate conductor plate (11, 12, 13) comprises an aluminium alloy or in particular a copper alloy, and the intermediate conductor plate (11, 12, 13) is accordingly produced from a solid complementary material a copper alloy or in particular an aluminium alloy.

4. Transmission control module (1) according to Claim 1, **characterized in that** the intermediate conductor plates (11, 12, 13) are produced from a roll-bonded combination plate.

5. Transmission control module (1) according to Claim 3 or 4, **characterized in that** the section (111, 121, 131) of the intermediate conductor plate (11, 12, 13), which section comprises at least one copper alloy surface or a solid copper alloy, is arranged in a region which is sealed off from transmission fluid in at least one sensor (4), in the at least one plug-in connector (5) and/or in the electronics module (2).

6. Transmission control module (1) according to Claim 5, **characterized in that** the section of the intermediate conductor plate (11, 12, 13), which section is arranged in the region which is sealed off transmission fluid, is embedded in a potting compound (43, 53, 23).

7. Transmission control module (1) according to one of Claims 4, 5 or 6, **characterized in that** the copper/aluminium transition region (123) of the intermediate conductor plate (12) outside a sealing material region is arranged in a housing interior (52) of the plug-in connector (5) in a manner protected against external fluids.

## Revendications

1. Module de commande de boîte de vitesses (1) d'un véhicule automobile, comportant :
un module électronique (2) comprenant un circuit électrique (3), une grille estampée (7),
au moins un capteur (4) à monter dans l'espace interne d'une boîte de vitesses,
au moins un connecteur (5) pour relier un branchement électrique entre l'espace interne et l'extérieur d'une boîte de vitesses,
dans lequel la grille estampée (7) est reliée de manière électroconductrice au module électronique (2), audit au moins un capteur (4) et audit au moins un connecteur (5), dans lequel le module de commande de boîte de vitesses (1) peut être monté dans l'espace interne d'une boîte de vitesses, **caractérisé en ce que** la grille estampée (7) est produite à partir d'un alliage d'aluminium et **en ce que** le module de commande de boîte de vitesses (1) comprend des plaques conductrices intermédiaires (11, 12, 13) qui sont disposées à chaque extrémité de ligne (71, 72) d'une ligne allant de la grille estampée (7) au module électronique (2), audit au moins un capteur et audit au moins un connecteur (5), dans lequel lesdites plaques conductrices intermédiaires (11, 12, 13) comprennent une extrémité de section (112, 122, 132) comportant un alliage d'Al et une extrémité de section opposée (111, 121, 131) comportant un alliage de Cu et par conséquent ayant une région de transition Cu/Al (123).

2. Module de commande de boîte de vitesses (1) selon la revendication 1, **caractérisé en ce que** la grille estampée (7) est soudée à l'aide d'une soudure de contact Al-Al, au niveau de ses extrémités (71, 72, 73) des lignes, aux sections (112, 122, 132) comprenant l'alliage Al des plaques conductrices intermédiaires (11, 12, 13), et les extrémités de lignes (33, 41) du module électronique (2), du capteur (4) et du connecteur (5) sont soudées à une extrémité de section en alliage de cuivre (111, 121, 131) de la plaque conductrice intermédiaire (11, 12, 13) respective.

3. Module de commande de boîte de vitesses (1) selon la revendication 1, **caractérisé en ce qu'**au moins une couche de surface d'une extrémité de section (111) de la plaque conductrice intermédiaire (11, 12, 13) comprend un alliage d'Al ou en particulier un alliage de Cu et **en ce que** la plaque conductrice intermédiaire (11, 12, 13) est produite de manière correspondante à partir d'un matériau complémentaire solide un alliage de Cu ou en particulier d'un alliage d'Al.

4. Module de commande de boîte de vitesses (1) selon la revendication 1, **caractérisé en ce que** les plaques conductrices intermédiaires (11, 12, 13) sont produites à partir d'une plaque combinée laminée au rouleau.

5. Module de commande de boîte de vitesses (1) selon la revendication 3 ou 4, **caractérisé en ce que** la section (111, 121, 131) de la plaque conductrice intermédiaire (11, 12, 13) qui comprend au moins une surface en alliage de Cu ou en alliage de Cu massif est disposée dans une zone étanche à l'huile de transmission dans ledit au moins un capteur (4), dans ledit au moins un connecteur (5) et/ou dans ledit module électronique (2).

6. Module de commande de boîte de vitesses (1) selon la revendication 5, **caractérisé en ce que** la partie de la plaque conductrice intermédiaire (11, 12, 13) qui est disposée dans la zone étanche huile de transmission est noyée dans une masse de coulée (43, 53, 23).

7. Module de commande de boîte de vitesses (1) selon l'une des revendications 4, 5 ou 6, **caractérisé en ce que** la zone de transition Cu/Al (123) de la plaque conductrice intermédiaire (12) est disposée à l'extérieur d'une zone de matériau d'étanchéité protégée des fluides extérieurs dans un espace interne de boîtier (52) du connecteur (5).
